(19) Europäisches Patentamt
European Patent Office
Office européen des brevets

(11) **EP 2 894 803 B1**

(12) **EUROPEAN PATENT SPECIFICATION**

(45) Date of publication and mention
of the grant of the patent:
**13.11.2019  Bulletin 2019/46**

(51) Int Cl.:
**H04L 1/00** *(2006.01)*          **H04L 12/24** *(2006.01)*

(21) Application number: **15150661.5**

(22) Date of filing: **09.01.2015**

(54) **Method and system for estimating parameter of data channel model in a communication system**

Verfahren und System zur Schätzung von Datenparametern von Kanalmodellen in einem Kommunikationssystem

Procédé et système pour estimer un paramètre de modèle de canal de données dans un système de communication

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.01.2014  KR 20140003730**

(43) Date of publication of application:
**15.07.2015  Bulletin 2015/29**

(73) Proprietor: **Samsung Electronics Co., Ltd. Gyeonggi-do 443-742 (KR)**

(72) Inventors:
 • **Kanievskyi, Oleksandr**
   **Gyeonggi-do 443-742 (KR)**
 • **Raievskyi, Mykola**
   **Gyeonggi-do 443-742 (KR)**
 • **Kopysov, Oleg**
   **Gyeonggi-do 443-742 (KR)**
 • **Hush, Roman**
   **Gyeonggi-do 443-742 (KR)**

(74) Representative: **HGF Limited**
   **Saviour House**
   **9 St. Saviourgate**
   **York YO1 8NQ (GB)**

(56) References cited:
**WO-A1-2006/120521      WO-A1-2010/041233**

• **SAMSUNG ELECTRONICS CO ET AL: "Proposed Source Blocking Algorithm and Simulation Results", 3GPP DRAFT; S4-121087_SAMSUNG_SBA_R1, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. SA WG4, no. Chicago, USA; 20120813 - 20120817 14 August 2012 (2012-08-14), XP050686847, Retrieved from the Internet: URL:http://www.3gpp.org/ftp/tsg_sa/WG4_COD EC/TSGS4_70/Docs/ [retrieved on 2012-08-14]**
• **CHU-SING YANG ET AL: "The analysis of packet loss prediction for Gilbert-model with loss rate uplink", MULTIMEDIA SIGNAL PROCESSING, 2002 IEEE WORKSHOP ON 9-11 DEC. 2002, PISCATAWAY, NJ, USA,IEEE, 19 May 2003 (2003-05-19), pages 526-530, XP010642425, ISBN: 978-0-7803-7713-4**

EP 2 894 803 B1

**Description**

<u>**TECHNICAL FIELD**</u>

The present disclosure relates to a method and a system for estimating a parameter in a communication system. More particularly, the present disclosure re lates to a method and a system for estimating a parameter of a data channel model i n a communication system.

<u>**BACKGROUND**</u>

Generally, there is noise in a communication channel of a communicati on system. Owing to the noise in the communication channel, a method of correctin g an error of data, which is transmitted owing to the noise, may be used, when data i s transmitted from a transmitting side to a receiving side, and one of the methods of correcting the error of data may include a Forward Error Correction (FEC).

In the FEC method, data is processed, or specific added information th at may be obtained from the data is generated as a parity field when the data is trans mitted from the transmitting side to the receiving side, where the parity field is a dded to the data which is to be transmitted, and the data is transmitted. At this time, the data to be transmitted is partitoned into parts. The sizes of the partitoned parts a re different according to the communication system. For example, a stream of data t o be transmitted is partitoned into predetermined sizes of packages according to a S ource Blocking Algorithm (SBA). The partitoned packages are encoded by a FEC en coder and are transmitted through a data channel.

The receiving side may receive the encoded packet, which is transmitte d through the data channel. Since the received packet is transmitted through a noise channel, the received packet may be a corrupt packet by noise. Therefore, the recei ving side may order the received packet by a Source Deblocking Algorithm (SDA) an d restore original data using the parity field in the corrupt packet, which is transmitted through the noise channel. Through the processes mentioned above, the received p acket may be determined as a reception success or a packet loss.

The above information is presented as background information only to assist with an understanding of the present disclosure. No determination has been m ade, and no assertion is made, as to whether any of the above might be applicable a s prior art with regard to the present disclosure.

WO-2006/120521-A1 discloses methods and apparatus to model a sys tem's channel and noise characteristics using one or more Hidden Markov Models b y modeling the state dynamics for one or more lines and associated profiles and by l earning from the line history.

Samsung Electronics Co. et al: "Proposed Source Blocking Algorithm a nd Simulation Results", 3GPP Draft; 3GPP TSG-SA4#70; 13-17 August 2012; S4-12 1087 discloses simulation results of a Source Blocking algorithm (proposed in S4-12 0719) on simulation conditions which is being defined by considering UTRAN-based MBMS streaming delivery service and which is based on "Table 8 Simulation conditi ons for UTRAN-based MBS" of S4-120552.

<u>**SUMMARY**</u>

Using a real data channel for testing new forward error correction (FEC ) encoder/decoder may cause inconvenience. For example, when the testing is appli ed to a real system, a time when a use of a data channel is less should be checked t o use the real system I, a time or a special and separate channel should be allocated . In addition, since an experiment or a test should be performed in various environm ents, it is very difficult to perform the experiment or the test in correspondence to a c ase according to these conditions.

The invention is described in its independent claims 1, 7 and 9. Preferred embodiments are stipulated in dependent claims while embodiments that do not fall under the scope of the claims are useful to understand the invention.

Aspects of the present disclosure are to address at least the above-me ntioned problems and/or disadvantages and to provide at least the advantages descr ibed below. Accordingly, an aspect of the present disclosure is to provide a simulatio n method in order to test new encoder/decoder.

A data channel form used in a simulation may be a form close to a data channel having real noise. When a model of a channel is assumed using such a for m, it is possible to simulate in a form similar to a real data channel.

When a new encoder/decoder is designed, the size of a parity field is d etermined according to the noise level of a data channel. When there is more noise, the parity field should become larger. When there is less noise, the parity field may become smaller. Thus, in order to accurately define the size of the parity field, simul ation data should be close to that of a real data channel as much as possible.

Another aspect of the present disclosure is to provide a method and a s ystem for accurately estimating a parameter of a data channel model in a predetermi ned communication system.

Another aspect of the present disclosure is to provide a method and a s ystem for estimating a parameter, which are capable of improving efficiency and incr easing a speed of FEC encoder/decoder.

Another aspect of the present disclosure is to provide a method and a s ystem for estimating parameters of a data channel in a static situation.

Another aspect of the present disclosure is to provide a method and a s ystem for estimating parameters of a data channel in a dynamic situation.

In accordance with an aspect of the present disclosure, a method of est imating a parameter of a data channel model in a communication system is provided. The method includes decoding a packet received through a noisy channel to conve rt the packet into data indicating one of a success and a failure of a reception of the packet, wherein packet reception is deemed successful if packet data is correctly rec eived or correction of the packet data is possible, and packet reception is deemed to have failed if packet data is incorrectly received and correction of the packet data is not possible, selecting a channel model having at least one unknown parameter, esti mating the at least one unknown parameter using the data indicating the one of the s uccess and the failure of the reception of the packet, and determining a size of a pari ty field of a FEC symbol, using the estimated at least one unknown parameter, wher ein the selected channel model corresponds to a Gilbert model in which a probability of successfully receiving a packet when in a burst error state is set to zero.

In accordance with another aspect of the present disclosure, a system f or estimating a parameter of a data channel model in a communication system is pro vided. The system includes a transmitting electronic device configured to construct a packet in a predetermined error correction encoding scheme and transmits the pack et, and a receiving electronic device configured to decode the packet received from t he transmitting electronic device through a noisy channel to convert the packet into data indicating one of a success and a failure of the reception of the packet, wherein packet reception is deemed sucessful if packet data is correctly received or correcti on of the packet data is possible, and packet reception is deemed to have failed if th e packet data is incorrectly received and correction of the packet data is not possible , to select a channel model having at least one unknown parameter, to estimate the at least one unknown parameter using the data indicating the one of the success and the failure of the reception of the packet, and determines a size of a parity field of a FEC symbol using the estimated at least one unknown parameter, wherein the select ed channel model corresponds to a Gilbert model in which a probability of successful ly receiving a packet when in a burst error state is set to zero.

Other aspects, advantages, and salient features of the disclosure will b ecome apparent to those skilled in the art from the following detailed description, whi ch, taken in conjunction with the annexed drawings, discloses various embodiments of the present disclosure.

## BRIEF DESCRIPTION OF THE DRAWINGS

The above and other aspects, features, and advantages of certain emb odiments of the present disclosure will be more apparent from the following descripti on taken in conjunction with the accompanying drawings, in which:

FIG. 1 is a conceptual construction diagram of a communication syste m which performs a simulation for estimating a parameter of a data channel accordin g to an embodiment of the present disclosure;

FIG. 2 is a flowchart illustrating a method of estimating a parameter of a data channel in a static situation according to an embodiment of the present disclo sure;

FIG. 3 is a view illustrating an example in which data converted to be u sed in a parameter estimation algorithm is partitioned according to an embodiment of the present disclosure;

FIG. 4 is a view illustrating a data channel model in a hidden Markov m odel (HMM) proposed according to an embodiment of the present disclosure;

FIG. 5 is a flowchart illustrating a method of estimating parameters in a prototype channel model according to an embodiment of the present disclosure; and

FIG. 6 is a conceptual construction diagram of a system for estimating a parameter of a data channel in a dynamic situation according to an embodiment of the present disclosure.

Throughout the drawings, it should be noted that like reference number s are used to depict the same or similar elements, features, and structures.

## DETAILED DESCRIPTION

The following description with reference to the accompanying drawings is provided to assist in a comprehensive understanding of various embodiments of t he present disclosure as defined by the claims. It includes vari ous specific details to assist in that understanding but these are to be regarded as m erely exemplary. Accordingly, those of ordinary skill in the art will recognize that vari ous changes and modifications of the various embodiments described herein may be made without departing from the scope of the present disclosure. In addition, descri ptions of well-known functions and constructions may be omitted for clarity and conci seness.

The terms and words used in the following description and claims are n ot limited to the bibliographical meanings, but, are merely used by the inventor to en able a clear and consistent understanding of the present disclosure. Accordingly, it s hould be apparent to those skilled in the art that the following description of various e mbodiments of the present disclosure is provided for illustration purpose only and not for the purpose of limiting the present disclosure as defined by the appended claims.

It is to be understood that the singular forms "a," "an," and "the" include plural referents unless the context clearly dictates otherwise. Thus, for example, refe rence to "a component surface" includes reference to one or more of such surfaces.

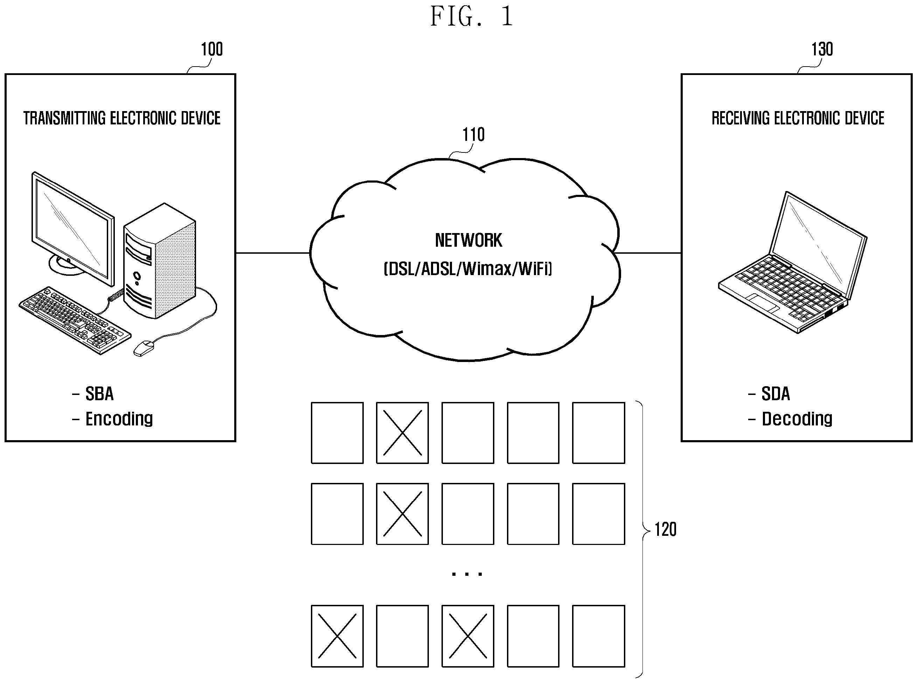

FIG. 1 is a conceptual construction diagram of a communication syste m that performs a simulation for estimating a parameter of a data channel according to an embodiment of the present disclosure.

Referring to FIG. 1, a communication system using a Forward Error Co rrection (FEC) scheme includes a transmitting electronic device 100, a receiving elec tronic device 130 and a network 110. The transmitting electronic device 100 may pa rtition data which is to be transmitted into parts having predetermined sizes based on a Source Blocking Algorithm (SBA) when the transmitting electronic device 100 may transmit the data, as described above. The transmitting electronic device 100 may encode the data according to the configured FEC scheme. Encoding the data accor ding to the FEC scheme may include processing the data or generating specific add ed information, which may be obtained from the data as a parity field and adding the parity field to the data to be transmitted, as described above.

The encoded data is transmitted through the network 110 to the receivi ng electronic device 130. At this time, the network 110 may be various networks suc h as a Digital Subscriber Line (DSL), an Asymmetric Digital Subscriber Line (ADSL), a World interoperability for Microwave Access (WiMax) and a Wireless Fidelity (WiFi) . In addition, as described above, noise may be basically included in each channel o f the network 110. The level of the noise may change according to characteristics of the network, a construction form of the network, an arrangement of the network, a nu mber of communication channels adjacent to the network, a number of channels whi ch are simultaneously connected for a communication, and the like. The size of the parity field is changed according to the change of the noise level. For example, whe n the noise level is high, the size of the parity field should become larger in order to s moothly transmit data. In contrast, when the noise level is low, that is, the noise is s mall, the size of the parity field may become smaller in order to smoothly transmit dat a.

The receiving electronic device 130 may receive the data transmitted th rough the network 110. The receiving electronic device 130 may order a received pa cket by a Source Deblocking Algorithm (SDA), as described above. The packet rece ived by the receiving electronic device 130 may be a corrupt packet owing to the nois e in the network 110. Thus, the receiving electronic device 130 may restore original data using the parity field in the corrupt packet. At this time, the original data of the p acket may be restored using the parity field, and the restoration to the original data of the packet may be impossible. This is shown as a reference numeral 120 of FIG. 1. Referring to the reference numeral 120, a packet of which corruption is deepend by t he noise and thus a restoration is impossible, among packets transmitted through th e network 110, is marked as "X".

The types of data transmitted by the FEC scheme as described above may include satellite navigation data, video data, voice streaming services, a video c hatting, a voice call, data transmitted from a satellite, and the like. More various type s of data may be transmitted according to a network usign the FEC scheme, in additi on to the above-mentioned data. Types of data are not limited in the present disclos ure.

Two types of various embodiments will be largely described using a wh ole system construction described above. As a first embodiment, a method of estim ating a parameter of a data channel in a static situation will be described. As a seco nd embodiment, a method of estimating a parameter of a data channel in a dynamic situation will be described.

First embodiment - a method of estimating a parameter of a data channel in a static situation

First, a data channel described in the first embodiment may be a data c hannel used in a system such as a DSL, an ADSL, a WiFi and a WiMax. The same data channel may be applied to other systems. In addition, a data channel, which ha s somewhat changed and has a form similar to the above-mentioned data channel, i n correspondence to a corresponding system may be applied to other systems. In a ddition, through the method of the first embodiment, a model for estimating a noise c hannel may be obtained and thus packet loss may be simulated. Therefore, when th e method according to the first embodiment is used, a parameter may be set (or defi ned) more accurately in the FEC scheme. Through this, when the method according to the present disclosure is applied to a specific data channel, the speed of an FEC encoder may be improved.

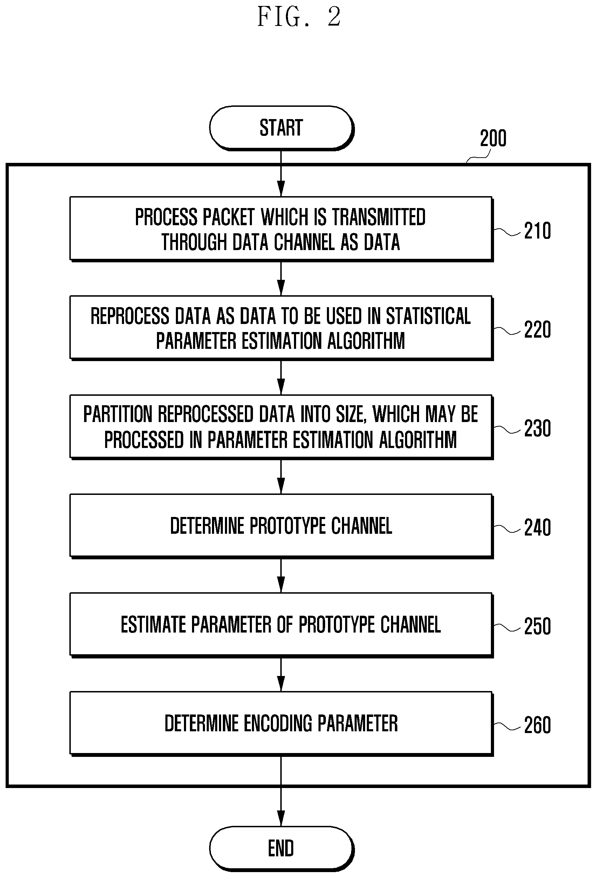

FIG. 2 is a flowchart illustrating a method of estimating a parameter of a data channel in a static situation according to the first embodiment of the present di sclosure.

Referring to FIG. 2, a method 200 of estimating a parameter of a data c hannel in a static situation is illustrated.

In operation 210, in order to estimate a para meter of a data channel, a receiving electronic device 130 may process a packet tran smitted through a data channel as data. The data channel may be a noise channel i ncluding noise as described above, and thus a portion or a whole of the transmitted packets may be corrupted by the noise. The corrupt packet (or a packet which may not be restored) may be basically regarded as a lost packet. Therefore, the transmitt ed packet becomes a successfully received packet (a case in which the packet is not caused by the noise or a case in which the correction of the packet is possible) or a l ost packet (a case in which the packet is corrupted caused by the noise or a case in which the correction of the packet is impossible).

Therefore, in operation 220, the receiving electronic device 130 may re process the data that is processed in the above-mentioned operation 210 as data to be used in a statistical parameter estimation algorithm. The statistical parameter esti mation algorithm will be described in more detail in operation 240. When the data is reprocessed as the data to be used in the statistical parameter estimation algorithm as described in the operation 220, according to an embodiment, statistical data may be expressed as '0' and '1'. For example, '0' may refer to a normally received packet , and '1' may refer to a lost packet. Alternatively, '0' may refer to the normally receiv ed packet, and '1' may refer to the lost packet.

After the receiving electronic device 130 may convert the data using th e statistical parameter estimation algorithm using the results of the conversion from t he packet into the data, in operation 230, the receiving electronic device 130 may pa rtition the data that is converted to be used in a parameter estimation algorithm into p redetermined units of several parts. This is for partitioning the data into a unit that is processed in the parameter estimation algorithm described later in operation 250. W hen the size of the unit that is processed in the parameter estimation algorithm is lar ger than the size of the data converted to be used in the parameter estimation algorit hm, monolithic data may be output. A reason to perform the operation 230 is becaus e the size of the data may be limited in processing the data in the parameter estimati on algorithm. However, as described abvoe, when the size of the data is not limited or the size of whole data is smaller than the limited size, operation 230 may not be n ecessary. Since the present disclosure describes a general case, it is assumed that the data converted to be used in the parameter estimation algorithm is partitioned.

An example in which the data converted to be used in the parameter es timation algorithm is partitioned will be described with reference to an accompanying drawing.

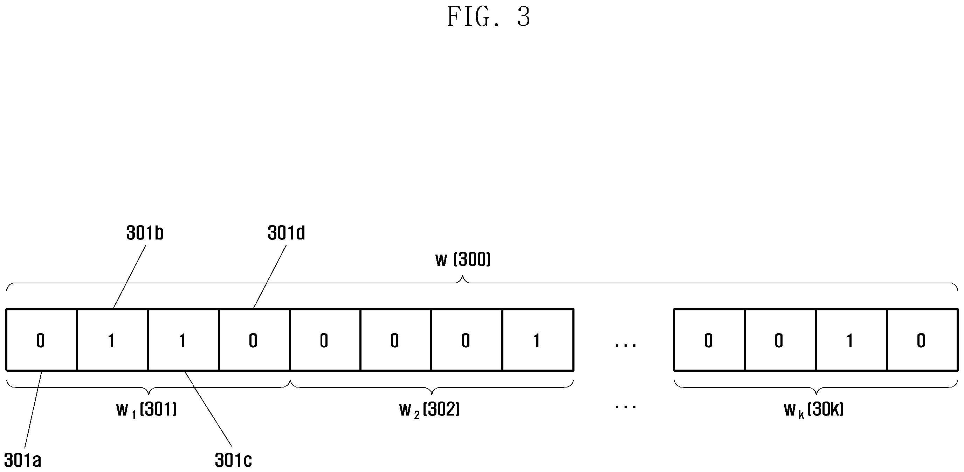

FIG. 3 is a view illustrating the example in which the data converted to be used in the parameter estimation algorithm is partitioned according to an embodi ment of the present disclosure.

Referring to FIG. 3, a stream of the data processed as '0' in a case of a successful reception and processed as '1' in a case of a loss, among the data conve rted to be used in the parameter estimation algorithm is shown. Referring to FIG. 3, ' W(300)' is whole data obtained from the packet, and successfully received data and l ost data are mixed in the whole data. In addition, in the example of FIG. 3, the whole data W(300) includes k partitoned sub groups $W_1(301)$, $W_2(302)$, ..., and Wk(30k). Each of the sub groups $W_1(301)$, $W_2(302)$, ..., and Wk(30k) may be processed as an average value by the parameter estimation algorithm as occasion demands.

Referring to FIG. 3, for example, one group, such as a first group $W_1(3 01)$ may include four converted data 301a, 301b, 301c and 301d. Here, one group m ay be an amount (or the size) of data which may be processed by the parameter esti mation algorithm. Therefore, the case shown in FIG. 3 is only an example, and it is o bvious that the amount (or the size) of the converted data in the one group may be c hanged according to a maximum value which may be acceptable by the parameter e stimation algorithm.

In operation 240, the receiving electronic device 130 may determine a prototype channel. Generally, there are many known models for simulating a loss of a packet in a communication system. A representative model includes a Bernoulli m odel, a Gilbert model, a Gilbert-Elliot model, and the like.

A model proposed in the present disclosure is similar to the Gilbert mo del except that the model proposed in the present disclosure does not allow burst los ses in the received packet. A channel model proposed in the present disclosure will be described with reference to an accompanying drawing.

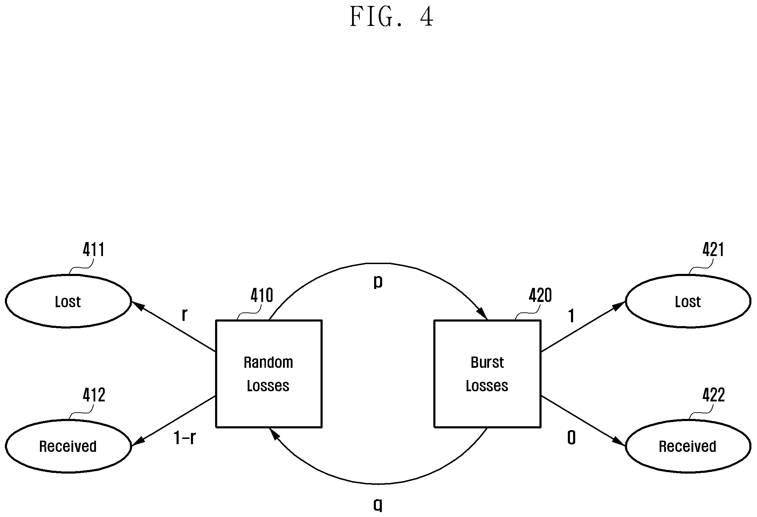

FIG. 4 is a view illustrating a data channel model in a hidden Markov m odel (HMM) proposed according to an embodiment of the present disclosure.

Referring to FIG. 4, losses are largely classified as a random losses sta te 410 and a burst losses state 420. In addition, a packet received in the random los ses state 410 may be classified as a case of a lost state 411 and a case of a normall y received state 412. In the same manner, a packet received in the burst losses stat e 420 may be classified as a case of a lost state 421 and a case of a normally receiv ed state 422.

The channel model proposed in the FIG. 4 may be defined as a form of a HMMs. When the channel model is defined as the form of the HMMs, a possiblity of the lost state 411 of the packet received in the case of the random losses state 41 0 is "r", and a possibility of the normally received state 422 of the packet received in t he case of the random losses state 410 is "1-r". In addition, when the channel model i s defined as the channel model of FIG. 4, in the case of the burst losses state 420, m ost of the received packet becomes the lost state 421 and does not become the nor mally received state 422.

In addition, a transition probability from the random losses state 410 to the burst losses sate 420 is "p", and a transition probability from the burst losses stat e 420 to the random losses state 410 is "q".

Referring to FIG. 4, theoretical models may be applied to various types of noise channels, and in order to apply the theoretical model of FIG. 4 to the noise c hannel, parameters of "p", "q" and "r" should be estimated.

Therefore, in the burst losses state 420, serial losses of the packets sh ould be simulated, and in the random losses state 410, discrete losses should be sim ulated. In the present disclosure, all models having at least one hidden state may be selected as a prototype of the channel model.

When the above-mentioned channel model of the prototype is s elected, in operation 250, the receiving electronic device estimates the parameter of the channel model of the prototype selected in operation 240. Referring to FIG. 4, it may be the case in which the parameters of "p", "q" and "r" are estimated.

A Maximum Likelihood Estimation (MLE) scheme may be used as a met hod of estimating an unknown parameter according to an embodiment of the present disclosure. Since it is impossible to obtain accurately a likelihood function based on an unknown MLE parameters, estimators may estimate parameters by an Expectatio n-Maximization (EM) algorithm. There is a Baum-Welch algorithm as a specific case of the EM algorithm.

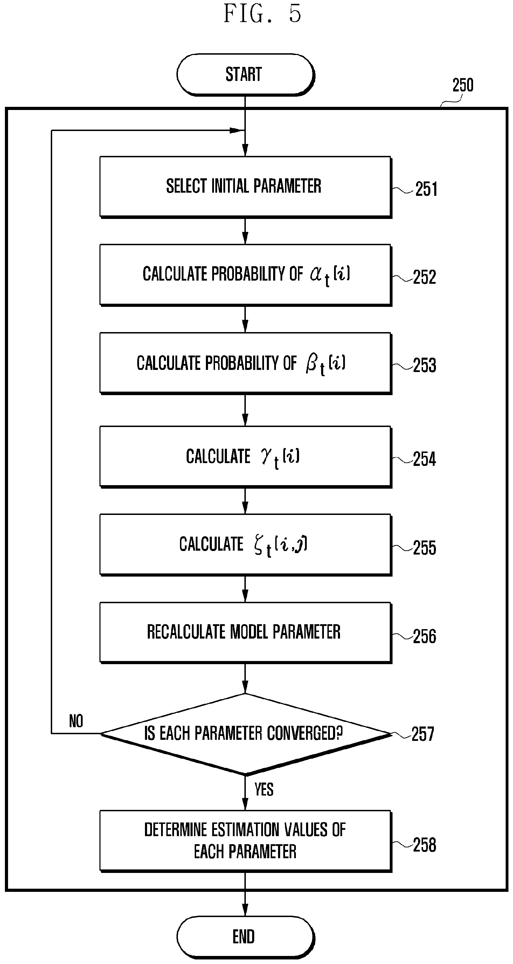

Parameters of the prototype channel may be estimated using any of th e EM algorithm, the Baum-Welch algorithm and an algorithm similar to these. A cas e in which any of these methods is used will be described with reference to FIG. 5.

FIG. 5 is a flowchart illustrating a method of estimating parameters in a prototype channel model according to an embodiment of the present disclosure.

Referring to FIG. 5, operations in the case in which the parameters of t he prototype channel are estimated using any of the the EM algorithm, the Baum-We lch algorithm and an algorithm similar to these, as described above the operation 25 0 are illustrated.

First, in operation 251, the receiving electronic device 130 may select i nitial parameters by Equation 1 below.

$$\pi = \left( \pi_1, \pi_2 \right),$$

$$A = \begin{pmatrix} a_{11} & a_{12} \\ a_{21} & a_{22} \end{pmatrix} = \begin{pmatrix} 1-p & p \\ q & 1-q \end{pmatrix},$$

$$B = \begin{pmatrix} b_{11} & b_{12} \\ b_{21} & b_{22} \end{pmatrix} = \begin{pmatrix} 1-r & r \\ 0 & 1 \end{pmatrix}, \quad \text{… Equation 1}$$

In Equation 1, $\pi$ may be a stationary distribution value for a matrix A, m ay correspond to an initial distribution, and may be defined as a uniform distribution when the stationary distribution does not exist. In addition, the matrix A is a matrix u sing the transition probability from the random losses state 410 to the burst losses st ate 420 in an environment such as the HMM described above with reference to FIG. 4. A matrix B is a matrix using a reception success probability and a loss probability of the packet in the random losses state 410. A process of calculating the matrix A a nd the matrix B will be described in more detail.

A channel between the transmitting electronic device 110 and the recei ving electronic device 130 is a noise channel. It is assumed that a distribution of the packets transmitted through the noise channel may be shown by a Markov chain. In addition, in the present disclosure, a HMM which is a more complicated construction, is selected, and the HMM is a model that is normalized from the Markov chain. A hi dden Markov chain used in the present disclosure is regarded as a Markov process having a plurality of hidden state. All Markov chains may be completely characterize d by an initial distribution ($p^0 = (p_1^0\ p_2^0,..., p_n^0)$)

Here, n is the number of possible states. $P_i^0$ is the probability which is t o be obtained from an i-th transition state, a transition probability matrix (or stochasti c matrix) and a Markov matrix. $P_i^0$ may be defined by Equation 2 below.

$$P_n = \begin{pmatrix} p_{1,1} & p_{1,2} & \cdots & p_{1,n} \\ p_{21} & & p_{j,k} & p_{2,n} \\ \vdots & & \ddots & \vdots \\ p_{n,1} & p_{n,2} & \cdots & p_{n,n} \end{pmatrix}$$

... Equation 2

In Equation 2, $P_{j,k}$ is a probability to be obtained from a j-th state to a k-t h state.

In addition, the HMM may be completely characterized by the initial dist ribution, the transition probability matrix and a density of Markov matrix, and may be defined by Equation 3 below.

$$P'_n = \begin{pmatrix} p'_{1,1} & p'_{1,2} & \cdots & p'_{1,m} \\ p'_{21} & & p'_{j,k} & p'_{2,m} \\ \vdots & & \ddots & \vdots \\ p'_{n,1} & p'_{n,2} & \cdots & p'_{n,m} \end{pmatrix}$$

... Equation 3

In Equation 3, $P'_{j,k}$ is a probability to be obtained in a k-th hidden state i n which a j-th state is provided, and m is the number of hidden states. As described above, the channel model illustrated in FIG. 4 becomes a matrix for describing the hi dden Markov matrix. Thus, Equation 2 and Equation 3 are defined by the matrix A a nd the matrix B from FIG. 4.

In operation 252, the receiving electronic device 130 may calculate a pr obability of $\alpha_t(i)$ using a forward-backward algorithm by Equation 4 below.

$$\alpha_t(i) = P\{d_1 d_2 \ldots d_t, q_t = x_i \mid \lambda\}$$

... Equation 4

In Equation 4, values of $D = d_1 d_2 \ldots d_T$ sequences observing se quences of 0 and 1, and $\lambda = (A, B, \pi)$ are parameters of the prototype chann el model the same as the above-mentioned example.

Important factors of the present disclosure is estimating parameters of p, q and r. The estimation may be calculated based on information observing seque nces of 0, which refers to a reception success and 1 which refers to a reception failur e. Thus, t is the number of observations. Parameter $\lambda$ is defined as a set of different parameters (e.g., A, B and $\pi$) on each repetition in the Baum-Welth algorithm, or is defined by the HMM model having the above-mentioned parameters (i.e., A, B and $\pi$ ). Parameter $(q_1)$ is a state of a process at a moment (t), and two types of states, for example, a) the random losses state and b) the burst losses state, are possible in th e proposed model.

Therefore, Equation 4 may be a probability obtained from t times of obs ervations, and may have the random losses state $(x_1)$ or the burst losses state $(X_2)$.

After the probability of $\alpha_t(i)$ is calculated by Equation 4, in operation 253 , the receiving electronic device may calculate a probability of $\beta_t(i)$ using the forward-backward algorithm by Equation 5.

$$\beta_t(i) = P\{d_{t+1} d_{t+2} \ldots d_T \mid q_t = x_i, \lambda\}$$

... Equation 5

In Equation 5, when a t-th state is $x_i$ and the channel model has the par ameters of A, B and $\pi$, a (t+1)-th observation refers to a probability that is $d_{t+1}$, a (t+2 )-th observation refers to a probability that is $d_{t+2}$, and a T-th observation refers to a p robability that is $d_T$.

After the probability of $\beta_t(i)$ is calculated by Equation 5, in operation 254 , the receiving electronic device 130 may calculate a probability of $\gamma_t(i) = P\{q_t = x_i \mid D, \lambda\}$ by Equation 6.

$$\gamma_t\left(i\right) = \frac{\alpha_t\left(i\right)\beta_t\left(i\right)}{\sum_{i=1}^{2}\alpha_t\left(i\right)\beta_t\left(i\right)}$$

… Equation 6

In Equation 6, $\gamma_t(i)$ refers to a probability of which the t-th state of t he channel model is $x_i$ when whole sequences (i.e., $d_1$, $d_2$, ..., dt) are observed and th e channel model has the parameters of A, B and $\pi$.

After the probability of $\gamma_t(i)$ is calculated, in operation 255, the rece iving electronic device 130 may calculate a probability of $\xi_t(i, j) = P\{q_t = x_i, q_{t+1} = x_j \mid D, \lambda\}$ by Equation 7.

$$\xi_t\left(i, j\right) = \frac{\alpha_t\left(i\right)a_{ij}b_{j\,d_{t+1}}\beta_{t+1}\left(j\right)}{\sum_{i=1}^{2}\sum_{j=1}^{2}\alpha_t\left(i\right)a_{ij}b_{j\,d_{t+1}}\beta_{t+1}\left(j\right)}$$

… Equation 7

In Equation 7, when a place where the packets are lost is known and th e channel model has the parameters of A, B and $\pi$, $\xi_t(i, j)$ refers to a probability that t he t-th state is $x_i$ and (t+1)-th state is $x_j$.

When all of the probabilities are calculated through the above-mentione d processes, in operation 256, the receiving electronic device 130 may recalculate th e parameters of the prototype channel by Equation 8.

$$\hat{\pi}_i = \gamma_1\left(i\right),$$

$$\hat{a}_{ij} = \frac{\sum_{t=1}^{T-1}\xi_t\left(i, j\right)}{\sum_{t=1}^{T-1}\gamma_t\left(i\right)},$$

$$\hat{b}_{ik} = \frac{\sum_{t:d_t=y_k}\gamma_t\left(i\right)}{\sum_{t=1}^{T}\gamma_t\left(i\right)}$$

… Equation 8

In operation 257, the receiving electronic device 130 may check wheth er an estimation value that is recalculated by Equation 8 converges on a predetermin ed value. In order to check whether or not the estimation value is converged on the predetermined value, the calculations of operations 251 to 256 should be operated r epetitively at least two or three times. According to the circumstances, the calculatio ns of operations 251 to 256 may be operated repetitively at least dozens of times. T hat is, the calculations of operations 251 to 256 should be operated sufficiently until t he recalculated values are converged on one value.

When the estimation value is initially calculated, since the receiving dev ice 130 may not check whether the estimation value converges on the predetermine d value, operation 251 may be performed after operation 257 is performed. In additi on, a method of determining the estimation value converges on the predetermined v alue may include storing the value obtained by Equation 8 at least a predetermined n umber of times and setting a convergence on a representative specific value when a deviation or a difference between the stores values is smaller than a predetermined value. In addition, another method of determining the estimation value converged on the predetermined value may include adding a weighted value to several values obt ained by Equation 8 and determining whether the estimation value converges on a s pecific value by operations.

When it is determined that the estimation value converges on one valu e as described above, in operation 258, the receiving electronic device 130 may dete rmine estimation values of each parameter. For example, the converged values may obtain estimation values $\hat{\lambda} = (\hat{A}, \hat{B}, \hat{\pi})$ of the parameters of the prototype chan nel model. When the estimation value of the prototype channel model is obtained as described above, $\hat{p} = \hat{a}_{12}$, $\hat{q} = \hat{a}_{21}$, $\hat{r} = \hat{b}_{12}$ may be estimated values "p", "q" and "r,", respectively.

A target of the algorithm according to the flowchart of FIG. 5 described above is increasing a probability obtained by Equation 9.

$$P\{D \mid \lambda\} = \sum_{Q} P\{D \mid Q, \lambda\} P\{Q \mid \lambda\}$$

$$= \sum_{q_1 q_2 \ldots q_T} b_{q_1 d_1} b_{q_2 d_2} \ldots b_{q_T d_T} \pi_{q_1} a_{q_1 q_2} \ldots a_{q_{T-1} q_T}$$

$$\ldots \text{Equation 9}$$

In Equation 9, $Q = q_1 q_2 \ldots q_T$ is a sequence of states.

The method of the present disclosure provides a method for estimating unknown parameters, which are obtained using the MLE scheme. The estimation va lues obtained by the MLE scheme has following characteristics.

    a. An asymptotic normality.
    b. When there is an estimation value, the estimation value obtained by the MLE scheme is effective.
    c. The value estimated by the MLE scheme has a consistence.

The above characteristic c indicates that the values estimated by the M LE scheme is considerably close to real values, when the number of observations is l arge enough.

Referring to FIG. 2 again, when the estimation of the parameter of the prototype channel is finished through the processs described above, in operation 26 0, the receiving electronic device 130 may determine an encoding parameter using t he the parameters calculated in operation 250. The determining of the encoding par ameter may refer to determing an amount (or the size) of a parity, which is a remaini ng part added to data as described above.

In addition, the estimation values calculated through the above-mention ed processes may be constructed as a table having a predetermined range to be pro vided. Other methods may be used.

Whole operations described above are described again. In operation 2 10, the receiving electronic device 130 receives the packet through the noise channe l, and converts the packet into the data. In operation 220, the receiving electronic de vice 130 may convert the data into information for applying to the statistical algorithm in correspondence to the reception success or failure of the data. In operation 230, the converted information is partitioned into the size which may be processed in the parameter estimation algorithm. In operation 240, the prototype channel, which is th e simulation model of the noise channel is determined. In operation 250, the receivin g electronic device 130 may estimate the parameters in correspondence to the protot ype channel, using the statistical information generated in operation 220. In operatio n 260, the receiving electronic device 130 may determine the size of the parity field t o be generated in the FEC encoder, using the estimated value.

The unknown parameters may be estimated in a predetermined chann el model through the operations described above. Here, the predetermined channel model is the noise channel. The parameters of the FEC encoder may be more accur ately defined in the noise channel, using the estimated parameters.

Second embodiment - a method of estimating a parameter of a data channel in a dynamic situation

The second embodiment is a case in which an Automatic Repeat reQu est (ARQ) of a corresponding channel is applied in addition to the above-mentioned f irst embodiment. For example, after receiving all feedback signals from a receiving e lectronic device 130, a parameter for a FEC encoding may be adjusted. Through thi s, when a noise channel is changed several times in a predetermined period (or a ti me interval), a FEC coding time may be remarkably reduced.

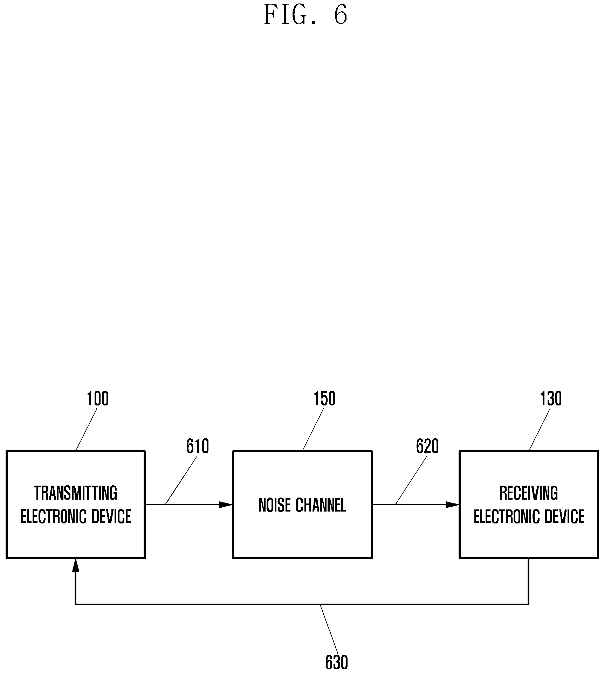

FIG. 6 is a conceptual construction diagram of a system for estimating a parameter of a data channel in a dynamic situation according to an embodiment of the present disclosure.

Referring to FIG. 6, a transmitting electronic device 100 may transmit d ata encoded through a predetermined FEC encoding scheme through a data channe l. This is the same as reference numeral 610. At this time, the transmitting electroni c device 100 may partition a stream of data to be transmitted into packages having p redetermined sizes according to a SBA. The partitioned package is encoded by a pr edetermined FEC encoder and is transmitted through the data channel.

The data transmitted from the transmitting electronic device 100 may b e transmitted through a noise channel 150. The noise channel 150 may be understo od as a noisy channel that inserts the noise into the packets transmitted from the tra nsmitting electronic device 100. Therefore, an error may occur in a portion or a whol e of the packets. The data of which the error occur may be transmitted to a receiving electronic device 130 as shown to a reference numeral 620 of FIG. 6.

The receiving electronic device 130 may receive the packet, which is tr ansmitted from the transmitting electronic device 100 through the noise channel 150, order the packets by a SDA, and restore original data using a parity field in a corrupt packet that is transmitted through the noise channel. This process may be understo od by referring to operation 210 of FIG. 2 described above.

The receiving electronic device 130 may perform operation 200 of FIG. 2 as described above. That is, the receiving electronic device 130 may determine an amount (or the size) of the parity field by performing operations 210 to 260. The det ermined amount (or the size) of the parity field is transmitted to the transmitting electr onic device 100 again as shown in reference numeral 630 of FIG. 6.

Therefore, the transmitting electronic device 100 may determine a parit y size during the FEC encoding according to the amount (or the size) of the parity fiel d which is provided from the receiving electronic device 130, constructing a packet u sing the determined size, and transmiting the packet.

As described above, when the channel is changed dynamically, in orde r to adaptably reflect the dynamic change of the channel, the receiving electronic dev ice transmits the determined size of the parity field to the transmitting electronic devi ce. Thus, the transmitting electronic device may perform the FEC encoding using a parameter provided from the receiving electronic device, that is, the size of the parity field which is optimized to the parity field.

Various aspects of the present disclosure can also be embodied as co mputer readable code on a non-transitory computer readable recording medium. A n on-transitory computer readable recording medium is any data storage device that c an store data which can be thereafter read by a computer system. Examples of the n on-transitory computer readable recording medium include Read-Only Memory (RO M), Random-Access Memory (RAM), CD-ROMs, magnetic tapes, floppy disks, and o ptical data storage devices. The non-transitory computer readable recording medium can also be distributed over network coupled computer systems so that the compute r readable code is stored and executed in a distributed fashion. Also, functional progr ams, code, and code segments for accomplishing the present disclosure can be easi ly construed by programmers skilled in the art to which the present disclosure pertain s.

At this point it should be noted that various embodiments of the present disclosure as described above typically involve the processing of input data and the generation of output data to some extent. This input data processing and output dat a generation may be implemented in hardware or software in combination with hard ware. For example, specific electronic components may be employed in a mobile de vice or similar or related circuitry for implementing the functions associated with the v arious embodiments of the present disclosure as described above. Alternatively, on e or more processors operating in accordance with stored instructions may impleme nt the functions associated with the various embodiments of the present disclosure a s described above. If such is the case, it is within the scope of the present disclosur e that such instructions may be stored on one or more non-transitory processor read able mediums. Examples of the processor readable mediums include Read-Only Me mory (ROM), Random-Access Memory (RAM), CD-ROMs, magnetic tapes, floppy di sks, and optical data storage devices. Also, functional computer programs, instructio ns, and instruction segments for accomplishing the present disclosure can be easily construed by programmers skilled in the art to which the present disclosure pertains.

While the present disclosure has been shown and described with refer ence to various embodiments thereof, it will be understood by those skilled in the art that various changes in form and details may be made therein without departing from the scope of the present disclosure as defined by the appended claims.

**Claims**

1. A method of estimating a parameter of a data channel model in a communication system, the method comprising:

decoding a packet received through a noisy channel to convert the packet into data indicating one of a success and a failure of a reception of the packet, wherein packet reception is deemed successful if packet data is correctly received or correction of the packet data is possible, and packet reception is deemed to have failed if packet data is incorrectly received and correction of the packet data is not possible;

selecting (240) a channel model for simulating the noisy channel, the channel model having at least one unknown parameter;

estimating (250) the at least one unknown parameter using the data indicating the one of the success and the failure of the reception of the packet; and

determining (260) a size of a parity field of a forward error correction, FEC, symbol, using the estimated at least one unknown parameter, wherein the selected channel model corresponds to a Gilbert model including a random losses state in which individual packets are lost and a burst losses state in which serial packets are lost, wherein a probability of successfully receiving a packet when in a burst losses state is set to zero, wherein there is a first predetermined transition probability for transitioning from the random losses state to the burst losses state and a second predetermined transition probability for transitioning from the burst losses state to the random losses state, and

wherein the data indicating the one of the success and the failure of the packet reception includes a data stream, and the method further includes partitioning data elements of the data stream into a determined unit of a sub group of data elements and performing the estimation of the at least one unknown parameter based on an average value of each sub group.

2. The method of claim 1, wherein the received packet is a packet encoded by a determined FEC symbol.

3. The method of claim 1, wherein the estimated at least one unknown parameter is stored as a table having a determined range.

4. The method of claim 1, further comprising:
transmitting the at least one unknown estimated parameter to a transmitting side.

5. A system for estimating a parameter of a data channel model in a communication system, the system comprising:

a transmitting electronic device (100) configured to construct a packet in a determined error correction encoding scheme and to transmit the packet; and
a receiving electronic device (130) configured:

to decode the packet received from the transmitting electronic device through a noisy channel to convert the packet into data indicating one of a success and a failure of the reception of the packet, wherien packet reception is deemed sucessful if packet data is correctly received or correction of the packet data is possible, and packet reception is deemed to have failed if the packet data is incorrectly received and correction of the packet data is not possible,

to select a channel model for simulating the noisy channel, the channel model having at least one unknown parameter,

to estimate the at least one unknown parameter using the data indicating the success or failure of the reception of the packet, and to determine a size of a parity field of a forward error correction, FEC, symbol using the estimated at least one unknown parameter, wherein the selected channel model corresponds to a Gilbert model including a random losses state in which individual packets are lost and a burst losses state in which serial packets are lost, wherein a probability of successfully receiving a packet when in a burst losses state is set to zero, and wherein there is a first predetermined transition probability for transitioning from the random losses state to the burst losses state and a second predetermined transition probability for transitioning from the burst losses state to the random losses state, and

wherein the receiving electronic device (130) is further configured to construct the data indicating the one of the success and the failure of the packet reception as a data stream, and partition data elements of the data stream into a determined unit of a sub group of data elements, and perform the estimation of the at least one unknown parameter based on an average value of each sub group.

6. The system of claim 5, wherein the estimated at least one unknown parameter is stored as a table having a determined range.

7. The system of claim 5, wherein the receiving electronic device (130) transmits the estimated at least one unknown parameter to a transmitting side.

**8.** The system of claim 7, wherein the transmitting electronic device (100) redetermines the size of a parity field, using the estimated at least one unknown parameter.

**9.** A non-transitory computer-readable storage medium storing instructions that, when executed on a computer, cause the computer to perform the method of claim 1.

**Patentansprüche**

**1.** Verfahren zum Schätzen eines Parameters eines Datenkanalmodells in einem Datenübertragungssystem, wobei das Verfahren aufweist:

ein Decodieren eines Pakets, das über einen verrauschten Kanal empfangen wird, um das Paket in Daten umzuwandeln, die entweder einen erfolgreichen oder nicht erfolgreichen Empfang des Pakets angeben, wobei der Paketempfang als erfolgreich erachtet wird, wenn die Paketdaten korrekt empfangen wurden oder eine Korrektur der Paketdaten möglich ist, und der Paketempfang als nicht erfolgreich erachtet wird, wenn die Paketdaten nicht korrekt empfangen wurden und keine Korrektur der Paketdaten möglich ist;
ein Auswählen (240) eines Kanalmodells zum Simulieren des verrauschten Kanals, wobei das Kanalmodell mindestens einen unbekannten Parameter hat;
ein Schätzen (250) des mindestens einen unbekannten Parameters unter Verwendung der Daten, die entweder den erfolgreichen oder nicht erfolgreichen Empfang des Pakets angeben; und
ein Bestimmen (260) einer Größe eines Paritätsfelds eines Vorwärtsfehlerkorrektur-, FEC, Symbols unter Verwendung des geschätzten mindestens einen unbekannten Parameters, wobei das ausgewählte Kanalmodell einem Gilbert-Modell entspricht, das einen zufallsbedingten Verlustezustand, in dem einzelne Pakete verloren gehen, und einen Burst-bedingten Verlustezustand enthält, in dem serielle Pakete verloren gehen, wobei eine Wahrscheinlichkeit eines erfolgreichen Empfangens eines Pakets, wenn es sich in einem Burst-bedingten Verlustezustand befindet, auf Null gesetzt ist, wobei eine erste vorbestimmte Übergangswahrscheinlichkeit für ein Übergehen aus dem zufallsbedingten Verlustezustand in den Burst-bedingten Verlustezustand und eine zweite vorbestimmte Übergangswahrscheinlichkeit für ein Übergehen aus dem Burst-bedingten Verlustezustand in den zufallsbedingten Verlustezustand vorhanden ist, und
wobei die Daten, die entweder den erfolgreichen oder nicht erfolgreichen Paketempfang angeben, einen Datenstrom enthalten, und das Verfahren ferner ein Partitionieren von Datenelementen des Datenstroms in eine bestimmte Einheit einer Untergruppe von Datenelementen und ein Ausführen der Schätzung des mindestens einen unbekannten Parameters auf Grundlage eines Durchschnittswerts jeder Untergruppe enthält.

**2.** Verfahren nach Anspruch 1, wobei das empfangene Paket ein Paket ist, das durch ein bestimmtes FEC-Symbol encodiert ist.

**3.** Verfahren nach Anspruch 1, wobei der geschätzte mindestens eine unbekannte Parameter als eine Tabelle mit einem bestimmten Bereich gespeichert ist.

**4.** Verfahren nach Anspruch 1, ferner aufweisend:
ein Übertragen des mindestens einen unbekannten geschätzten Parameters zu einer Übertragungsseite.

**5.** System zum Schätzen eines Parameters eines Datenkanalmodells in einem Datenübertragungssystem, wobei das System aufweist:
eine übertragende elektronische Einheit (100), die konfiguriert ist, um ein Paket in einem bestimmten Fehlerkorrektur-Codierschema zu erstellen und das Paket zu übertragen; und eine empfangende elektronische Einheit (130), die konfiguriert ist:

um das Paket zu decodieren, das von der übertragenden elektronischen Einheit über einen verrauschten Kanal empfangen wird, um das Paket in Daten umzuwandeln, die entweder den erfolgreichen oder nicht erfolgreichen Empfang des Pakets angeben, wobei der Paketempfang als erfolgreich erachtet wird, wenn die Paketdaten korrekt empfangen wurden oder eine Korrektur der Paketdaten möglich ist, und der Paketempfang als nicht erfolgreich erachtet wird, wenn die Paketdaten nicht korrekt empfangen wurden und keine Korrektur der Paketdaten möglich ist,
um ein Kanalmodell zum Simulieren des verrauschten Kanals auszuwählen, wobei das Kanalmodell mindestens einen unbekannten Parameter hat,

um den mindestens einen unbekannten Parameter unter Verwendung der Daten zu schätzen, die entweder den erfolgreichen oder nicht erfolgreichen Empfang des Pakets angeben, und

um eine Größe eines Paritätsfelds eines Vorwärtsfehlerkorrektur-, FEC, Symbols unter Verwendung des geschätzten mindestens einen unbekannten Parameters zu bestimmen, wobei das ausgewählte Kanalmodell einem Gilbert-Modell entspricht, das einen zufallsbedingten Verlustezustand, in dem einzelne Pakete verloren gehen, und einen Burst-bedingten Verlustezustand enthält, in dem serielle Pakete verloren gehen, wobei eine Wahrscheinlichkeit eines erfolgreichen Empfangens eines Pakets, wenn es sich in einem Burst-bedingten Verlustezustand befindet, auf Null gesetzt ist, wobei eine erste vorbestimmte Übergangswahrscheinlichkeit für ein Übergehen aus dem zufallsbedingten Verlustezustand in den Burst-bedingten Verlustezustand und eine zweite vorbestimmte Übergangswahrscheinlichkeit für ein Übergehen aus dem Burst-bedingten Verlustezustand in den zufallsbedingten Verlustezustand vorhanden ist, und

wobei die empfangende elektronische Einheit (130) ferner konfiguriert ist, um die Daten, die entweder den erfolgreichen oder nicht erfolgreichen Paketempfang angeben, als einen Datenstrom zu erstellen, und um Datenelemente des Datenstroms in eine bestimmte Einheit einer Untergruppe von Datenelementen zu partitionieren und die Schätzung des mindestens einen unbekannten Parameters auf Grundlage eines Durchschnittswerts jeder Untergruppe auszuführen.

**6.** System nach Anspruch 5, wobei der geschätzte mindestens eine unbekannte Parameter als eine Tabelle mit einem bestimmten Bereich gespeichert ist.

**7.** System nach Anspruch 5, wobei die empfangende elektronische Einheit (130) den mindestens einen unbekannten geschätzten Parameter zu einer Übertragungsseite überträgt.

**8.** System nach Anspruch 7, wobei die übertragende elektronische Einheit (100) die Größe eines Paritätsfelds unter Verwendung des geschätzten mindestens einen unbekannten Parameters bestimmt.

**9.** Nicht flüchtiges, durch einen Computer lesbares Speichermedium, das Anweisungen speichert, die bei Ausführung auf einem Computer den Computer veranlassen, das Verfahren nach Anspruch 1 auszuführen.

## Revendications

**1.** Procédé pour estimer un paramètre d'un modèle de canal de données dans un système de communication, le procédé comprenant :

le décodage d'un paquet reçu par l'intermédiaire d'un canal bruyant pour convertir le paquet en données indiquant l'un de la réussite et de l'échec de la réception du paquet, la réception de paquet étant estimée réussie si les données de paquet sont reçues correctement ou la correction des données de paquet est possible, et la réception de paquet étant estimée avoir échouée si les données de paquet ne sont pas reçues correctement et la correction des données de paquet n'est pas possible ;

la sélection (240) d'un modèle de canal pour simuler le canal bruyant, le modèle de canal comportant au moins un paramètre inconnu ;

l'estimation (250) dudit au moins un paramètre inconnu à l'aide des données indiquant l'un de la réussite et de l'échec de la réception du paquet ; et

la détermination (260) de la taille d'un champ de parité d'un symbole de correction aval des erreurs (FEC), à l'aide dudit au moins un paramètre inconnu estimé, ledit modèle de canal sélectionné correspondant à un modèle de Gilbert comprenant un état de pertes aléatoires dans lequel des paquets individuels sont perdus et un état de pertes en rafales dans lequel des paquets en séries sont perdus, la probabilité de la réception réussie d'un paquet dans un état de pertes en rafales étant fixée à zéro, dans lequel il existe une première probabilité de transition prédéfinie pour passer de l'état de pertes aléatoires à l'état de pertes en rafales et une seconde probabilité de transition prédéfinie pour passer de l'état de pertes en rafales à l'état de pertes aléatoires, et lesdites données indiquant l'un de la réussite et de l'échec de la réception de paquet comprenant un flux de données, et le procédé comprenant en outre le partitionnement d'éléments de données du flux de données en unité définie d'un sous-groupe d'éléments de données et la réalisation de l'estimation dudit au moins un paramètre inconnu sur la base d'une valeur moyenne de chaque sous-groupe.

**2.** Procédé selon la revendication 1, ledit paquet reçu étant un paquet codé par un symbole FEC défini.

3. Procédé selon la revendication 1, ledit au moins un paramètre inconnu estimé étant stocké sous la forme d'un tableau présentant une plage définie.

4. Procédé selon la revendication 1, comprenant :
la transmission dudit au moins un paramètre inconnu estimé à un côté transmission.

5. Système pour estimer un paramètre d'un modèle de canal de données dans un système de communication, le système comprenant :

un dispositif électronique de transmission (100) configuré pour construire un paquet dans un schéma de codage de correction d'erreurs défini et pour transmettre le paquet ; et
un dispositif électronique de réception (130) configuré :

pour décoder le paquet reçu en provenance du dispositif électronique de transmission par l'intermédiaire d'un canal bruyant pour convertir le paquet en données indiquant l'un de la réussite et de l'échec de la réception du paquet, la réception de paquet étant estimée réussie si les données de paquet sont reçues correctement ou la correction des données de paquet est possible, et la réception de paquet étant estimée avoir échouée si les données de paquet ne sont pas reçues correctement et la correction des données de paquet n'est pas possible,
pour sélectionner un modèle de canal pour simuler le canal bruyant, le modèle de canal comportant au moins un paramètre inconnu,
pour estimer ledit au moins un paramètre inconnu à l'aide des données indiquant la réussite ou l'échec de la réception du paquet, et
pour déterminer la taille d'un champ de parité d'un symbole de correction aval des erreurs (FEC) à l'aide dudit au moins un paramètre inconnu estimé, ledit modèle de canal sélectionné correspondant à un modèle de Gilbert comprenant un état de pertes aléatoires dans lequel des paquets individuels sont perdus et un état de pertes en rafales dans lequel des paquets en séries sont perdus, la probabilité de la réception réussie d'un paquet lorsqu'il se trouve dans un état de pertes en rafales étant fixée à zéro, et dans lequel il existe une première probabilité de transition prédéfinie pour passer de l'état de pertes aléatoires à l'état de pertes en rafales et une seconde probabilité de transition prédéfinie pour passer de l'état de pertes en rafales à l'état de pertes aléatoires, et
ledit dispositif électronique de réception (130) étant en outre configuré pour construire les données indiquant l'un de la réussite et de l'échec de la réception de paquet sous la forme d'un flux de données, et partitionner des éléments de données du flux de données en unité définie d'un sous-groupe d'éléments de données, et réaliser l'estimation dudit au moins un paramètre inconnu sur la base d'une valeur moyenne de chaque sous-groupe.

6. Système selon la revendication 5, ledit au moins un paramètre inconnu estimé étant stocké sous la forme d'un tableau présentant une plage définie.

7. Système selon la revendication 5, ledit dispositif électronique de réception (130) transmettant ledit au moins un paramètre inconnu estimé à un côté transmission.

8. Système selon la revendication 7, ledit dispositif électronique de transmission (100) redéterminant la taille d'un champ de parité, à l'aide dudit au moins un paramètre inconnu estimé.

9. Support de stockage non transitoire lisible par ordinateur stockant des instructions qui, lorsqu'elles sont exécutées sur un ordinateur, incitent l'ordinateur à exécuter le procédé selon la revendication 1.

# FIG. 1

TRANSMITTING ELECTRONIC DEVICE

NETWORK
(DSL/ADSL/Wimax/WiFi)

RECEIVING ELECTRONIC DEVICE

- SBA
- Encoding

- SDA
- Decoding

EP 2 894 803 B1

FIG. 2

```
                    ┌─────────────┐
                    │    START    │
                    └──────┬──────┘              200
                           │                  ╭──
    ┌──────────────────────┼──────────────────────────┐
    │                      ▼                           │
    │  ┌─────────────────────────────────────────┐    │
    │  │   PROCESS PACKET WHICH IS TRANSMITTED    │    │
    │  │      THROUGH DATA CHANNEL AS DATA        │────┼── 210
    │  └─────────────────────┬───────────────────┘    │
    │                        ▼                         │
    │  ┌─────────────────────────────────────────┐    │
    │  │  REPROCESS DATA AS DATA TO BE USED IN    │    │
    │  │  STATISTICAL PARAMETER ESTIMATION        │────┼── 220
    │  │  ALGORITHM                               │    │
    │  └─────────────────────┬───────────────────┘    │
    │                        ▼                         │
    │  ┌─────────────────────────────────────────┐    │
    │  │ PARTITION REPROCESSED DATA INTO SIZE,    │    │
    │  │ WHICH MAY BE PROCESSED IN PARAMETER      │────┼── 230
    │  │ ESTIMATION ALGORITHM                     │    │
    │  └─────────────────────┬───────────────────┘    │
    │                        ▼                         │
    │  ┌─────────────────────────────────────────┐    │
    │  │        DETERMINE PROTOTYPE CHANNEL       │────┼── 240
    │  └─────────────────────┬───────────────────┘    │
    │                        ▼                         │
    │  ┌─────────────────────────────────────────┐    │
    │  │  ESTIMATE PARAMETER OF PROTOTYPE CHANNEL │────┼── 250
    │  └─────────────────────┬───────────────────┘    │
    │                        ▼                         │
    │  ┌─────────────────────────────────────────┐    │
    │  │       DETERMINE ENCODING PARAMETER       │────┼── 260
    │  └─────────────────────┬───────────────────┘    │
    │                        │                         │
    └────────────────────────┼─────────────────────────┘
                             ▼
                    ┌─────────────┐
                    │     END     │
                    └─────────────┘
```

FIG. 3

EP 2 894 803 B1

# FIG. 4

FIG. 5

```
           ┌─────────┐
           │  START  │
           └─────────┘
                │
    ┌───────────┼──────────────────────────────┐  ~250
    │           ▼                                │
    │   ┌──────────────────────────┐            │
    │→  │ SELECT INITIAL PARAMETER │  ~251      │
    │   └──────────────────────────┘            │
    │           ▼                                │
    │   ┌────────────────────────────────┐      │
    │   │ CALCULATE PROBABILITY OF α_t[i]│ ~252 │
    │   └────────────────────────────────┘      │
    │           ▼                                │
    │   ┌────────────────────────────────┐      │
    │   │ CALCULATE PROBABILITY OF β_t[i]│ ~253 │
    │   └────────────────────────────────┘      │
    │           ▼                                │
    │   ┌──────────────────────┐                │
    │   │ CALCULATE  γ_t[i]    │  ~254          │
    │   └──────────────────────┘                │
    │           ▼                                │
    │   ┌──────────────────────┐                │
    │   │ CALCULATE  ζ_t[i,j]  │  ~255          │
    │   └──────────────────────┘                │
    │           ▼                                │
    │   ┌──────────────────────────┐            │
    │   │ RECALCULATE MODEL PARAMETER│ ~256     │
    │   └──────────────────────────┘            │
    │           ▼                                │
    │ NO ◇ IS EACH PARAMETER CONVERGED? ◇ ~257  │
    │           │ YES                            │
    │           ▼                                │
    │   ┌──────────────────────────────┐        │
    │   │ DETERMINE ESTIMATION VALUES OF│ ~258  │
    │   │       EACH PARAMETER          │        │
    │   └──────────────────────────────┘        │
    └───────────┼──────────────────────────────┘
                ▼
           ┌─────────┐
           │   END   │
           └─────────┘
```

# FIG. 6

TRANSMITTING ELECTRONIC DEVICE 100 → 610 → NOISE CHANNEL 150 → 620 → RECEIVING ELECTRONIC DEVICE 130 → 630

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006120521 A1

**Non-patent literature cited in the description**

- **SAMSUNG ELECTRONICS CO. et al.** Proposed Source Blocking Algorithm a nd Simulation Results. *3GPP Draft; 3GPP TSG-SA4#70,* 13 August 2012, 4-121087

- *Table 8 Simulation conditi ons for UTRAN-based MBS,* 4-120552